(19) Europäisches Patentamt
European Patent Office
Office européen des brevets

(11) **EP 4 730 981 A1**

(12) **EUROPEAN PATENT APPLICATION**

(43) Date of publication:
**22.04.2026 Bulletin 2026/17**

(21) Application number: **25206408.4**

(22) Date of filing: **02.10.2025**

(51) International Patent Classification (IPC):
*H10W 70/692* (2026.01)     *H10W 74/01* (2026.01)
*H10W 74/00* (2026.01)     *H10W 70/60* (2026.01)

(52) Cooperative Patent Classification (CPC):
**H10W 70/692; H10W 70/68; H10W 74/114;**
H10W 70/614; H10W 70/682

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **15.10.2024 US 202463707741 P**
**26.12.2024 US 202463739108 P**

(71) Applicant: **Absolics Inc.**
**Covington, GA 30014 (US)**

(72) Inventors:
• **LEE, Si Hun**
**Covington, Georgia, 30014 (US)**
• **KIM, Tae Kyoung**
**Covington, Georgia, 30014 (US)**
• **LEE, Younggyu**
**Covington, Georgia, 30014 (US)**

(74) Representative: **BCKIP Part mbB**
**MK1**
**Landsbergerstraße 98, 3.Stock**
**80339 München (DE)**

(54) **MANUFACTURE METHOD FOR A PACKAGING SUBSTRATE**

(57)     A method of manufacturing a packaging substrate according to the present disclosure comprises: a preparation step of preparing a preliminary substrate which comprises a core layer in which a cavity portion comprises a device mounting space and an inner side surface of the cavity surrounding the device mounting space; a surface treatment step of increasing surface energy of at least a portion of the inner side surface of the cavity; a device portion mounting step which comprises mounting a device portion on the cavity portion after the surface treatment step is completed; and an encapsulation layer forming step of forming an encapsulation layer which comprises surrounding at least a portion of the surface of the device portion with an encapsulation layer-forming composition, thereby manufacturing the packaging substrate.

In this case, defects that may occur in a process of forming the encapsulation layer and an insulating layer in the packaging substrate may be effectively suppressed.

EP 4 730 981 A1

# EP 4 730 981 A1

## Description

This application claims the priority benefit of U.S. Provisional Patent Application No. 63/739,108, filed on December 26, 2024 and U.S. Provisional Patent Application No. 63/707,741, filed on October 15, 2024.

### BACKGROUND

### 1. Field

The present disclosure relates to a manufacture method for a packaging substrate.

### 2. Discussion of Related Art

In manufacturing electronic components, implementing circuits on a semiconductor wafer is called the front-end process (FE), and assembling the wafer into a state that can actually be used in a product is called the back-end process (BE), and the packaging process is included in this back-end process.

Recently, four core technologies of the semiconductor industry that enabled the rapid development of electronic products are semiconductor technology, semiconductor packaging technology, manufacturing process technology, and software technology. Semiconductor technology has been developed in various forms, such as line width in sub-micron or nano units, more than tens of millions of cells, high-speed operation, and large heat dissipation, but relatively, the technology for perfectly packaging them has not been supported. Accordingly, the electrical performance of semiconductors may be determined by the packaging technology and the electrical connection according to the packaging rather than the performance of the semiconductor technology itself.

As materials of packaging substrates, ceramic or resin is applied. In the case of a ceramic substrate, it has high resistance value or high dielectric constant, and thus it is not easy to mount high-performance high-frequency semiconductor devices. In the case of a resin substrate, relatively high-performance high-frequency semiconductor devices may be mounted, but there is a limit to reducing the wiring pitch.

Recently, studies applying silicon or glass as high-end packaging substrates are in progress. In a silicon or glass substrate, through holes are formed and a conductive material is applied to the through holes, so that the wiring length between the device and the motherboard becomes short and excellent electrical characteristics may be obtained.

### SUMMARY

A manufacture method for a packaging substrate according to one embodiment of the present specification comprises:

a preparation step of preparing a preliminary substrate including a core layer in which a cavity portion including a device mounting space and an inner side surface of the cavity surrounding the device mounting space is formed;
a surface treatment step of increasing surface energy of at least a portion of the inner side surface of the cavity;
a device mounting step of mounting a device portion in the cavity portion after the surface treatment step; and
an encapsulation layer forming step of forming an encapsulation layer surrounding at least a portion of the surface of the device portion with an encapsulation layer-forming composition, thereby manufacturing a packaging substrate.

The preliminary substrate may further include a cavity conductive layer formed on the inner side surface of the cavity.

The inner side surface of the cavity may include an exposed region not covered by the cavity conductive layer.

In the surface treatment step, the surface energy of the cavity conductive layer and the exposed region may be increased.

In the surface treatment step, at least a portion of the inner side surface of the cavity may be plasma-treated.

In the surface treatment step, the cavity conductive layer and the exposed region may be plasma-treated.

In the surface treatment step, an ambient gas may include 50 vol% or more of oxygen gas.

In the surface treatment step, plasma power may be 50 W or more.

The surface treatment step may be carried out for 15 seconds to 60 seconds.

In the surface treatment step, plasma treatment may be performed with 50 sccm to 1000 sccm of ambient gas.

In the surface treatment step, a contact angle of water to the inner side surface of the cavity may be adjusted to 60° or less.

The device portion may include a side surface disposed apart from the inner side surface of the cavity.

A gap aspect ratio Arg of Equation 1 below may be 30 or less.

[Equation 1]

$$Arg = \frac{eh}{g}$$

In Equation 1, eh is a height of the device portion, and g is a minimum distance between a first point located on a side surface of the device portion and a second point located on the inner side surface of the cavity.

The g value may be 20 $\mu$m to 500 $\mu$m.

A viscosity of the encapsulation layer-forming composition at 25°C may be 12,000 cps to 38,000 cps.

The encapsulation layer-forming composition may include 45 wt% or more and 80 wt% or less of filler.

A difference value between a coefficient of thermal expansion $\alpha1$ of the encapsulation layer and a coefficient of thermal expansion of the glass core may be 40 ppm/°C or less.

A coefficient of thermal expansion $\alpha2$ of the encapsulation layer may be 140 ppm/°C or less.

A modulus of elasticity of the encapsulation layer may be 10 GPa to 300 GPa.

A glass transition temperature of the encapsulation layer may be 70°C to 130°C.

The encapsulation layer-forming composition may comprise an epoxy-based resin and a curing agent.

A method of manufacturing a packaging substrate according to another embodiment of the present specification comprises:

a preparation step of preparing a preliminary substrate including a glass core on which a device portion including a device is mounted; and

an encapsulation layer forming step of manufacturing the packaging substrate by forming an encapsulation layer surrounding at least a portion of the device portion with an encapsulation layer-forming composition.

The glass core comprises a cavity portion that is a space formed by being recessed on an upper surface side of the glass core.

The device portion is disposed in the cavity portion.

A viscosity of the encapsulation layer-forming composition at 25°C is 12,000 cps to 38,000 cps.

The cavity portion may comprise a cavity opening disposed on the upper surface side of the glass core, a cavity inner side surface connected with the cavity opening and extending in a thickness direction of the glass core, and an device mounting space surrounded by the cavity inner side surface.

At least one side surface of the device portion may be disposed to be spaced apart from the cavity inner side surface facing the one side surface of the device portion.

The encapsulation layer forming step may comprise a placement process of placing the encapsulation layer-forming composition between the cavity inner side surface and one side surface of the device portion, and a curing process of curing the encapsulation layer-forming composition to form the encapsulation layer.

The preliminary substrate may have the gap aspect ratio (Arg) of 30 or less as represented by the Equation 1.

The g value may be 20 $\mu$m to 500 $\mu$m.

A difference value between a coefficient of thermal expansion $\alpha1$ of the encapsulation layer and a coefficient of thermal expansion of the glass core may be 40 ppm/°C or less.

A coefficient of thermal expansion $\alpha2$ of the encapsulation layer may be 140 ppm/°C or less.

A modulus of elasticity of the encapsulation layer may be 10 GPa to 300 GPa.

A glass transition temperature of the encapsulation layer may be 70°C to 130°C.

The encapsulation layer-forming composition may comprise an epoxy-based resin and a curing agent.

The encapsulation layer-forming composition may comprise a filler in an amount of 45 wt% or more and 80 wt% or less.

BRIEF DESCRIPTION OF THE DRAWINGS

FIG. 1 is a cross-sectional view illustrating a preliminary substrate prepared through a preparation step according to an embodiment of the present disclosure.

FIG. 2 is a cross-sectional view illustrating a preliminary substrate prepared through a device mounting step according to an embodiment of the present disclosure.

FIG. 3 is a cross-sectional view illustrating a packaging substrate prepared through an encapsulation layer forming step according to an embodiment of the present disclosure.

FIG. 4 is a cross-sectional view illustrating a preliminary substrate prepared through a preparation step according to another embodiment of the present disclosure.

FIG. 5 is a cross-sectional view illustrating a packaging substrate prepared through an encapsulation layer forming step according to another embodiment of the present disclosure.

## DETAILED DESCRIPTION

Hereinafter, exemplary embodiments will be described in detail with reference to the accompanying drawings so that those skilled in the art to which the present invention pertains may easily carry out the invention. However, the present invention may be implemented in various different forms and is not limited to the embodiments described herein. Throughout the specification, the same reference numerals are assigned to similar parts.

Throughout this specification, the term "a combination thereof" included in a Markush-type expression means a mixture or combination of one or more selected from the group of elements described in the Markush-type expression, and means that one or more selected from the group of the elements are included.

Throughout this specification, terms such as "first," "second," or "A," "B," are used to distinguish the same terms from each other. In addition, unless the singular expression clearly means otherwise in the context, the singular expression includes the plural expression.

In this specification, "~ based" may mean that the compound contains a compound corresponding to "~" and/or a derivative of "~" in the compound.

In this specification, the meaning that B is located on A means not only that B is located directly on A but also that another layer is interposed between them, and thus B is located on A. It is not limitedly interpreted that B is located in direct contact with the surface of A.

In this specification, the meaning that B is connected to A means that A and B are directly connected or connected through another component between A and B, and unless otherwise specified, it is not limitedly interpreted that A and B are directly connected.

In this specification, a singular expression is interpreted to include both singular and plural as interpreted in the context unless there is a special description.

In this specification, shapes, relative sizes, angles, etc., of each component in the drawings may be exaggerated for illustration purposes, and rights are not limitedly interpreted to the drawings.

In this specification, that A and B are adjacent means that A and B are in contact with each other or located close to each other without contact. The expression that A and B are adjacent is not limitedly interpreted as A and B being in contact with each other unless otherwise specified.

In this specification, unless otherwise specified, property values of each component in the packaging substrate are interpreted as those measured at room temperature. Room temperature is 20°C to 25°C.

After a device is mounted in a cavity in the core layer, defects may occur during the process of encapsulating the device. Specifically, voids may occur in the encapsulation layer surrounding the device, or undulation may occur in an insulating layer formed on the encapsulation layer. Such a phenomenon may more frequently occur when a conductive layer is implemented on the inner side surface of the cavity.

The inventors of the present disclosure experimentally confirmed that by introducing the technical features to be described below, defects occurring in the encapsulation layer and the insulating layer may be suppressed, and a manufacture method for a packaging substrate having stable durability and electrical reliability may be provided, thereby completing the present disclosure.

Hereinafter, the present disclosure will be described in detail.

The manufacture method for a packaging substrate of the present disclosure comprises: a preparation step of preparing a preliminary substrate including a core layer in which a cavity portion including a device mounting space and an inner side surface of the cavity surrounding the device mounting space is formed; a surface treatment step of increasing surface energy of at least a portion of the inner side surface of the cavity; a device mounting step of mounting a device portion in the cavity portion after the surface treatment step; and an encapsulation layer forming step of forming an encapsulation layer surrounding at least a portion of the surface of the device with an encapsulation layer-forming composition, thereby manufacturing a packaging substrate.

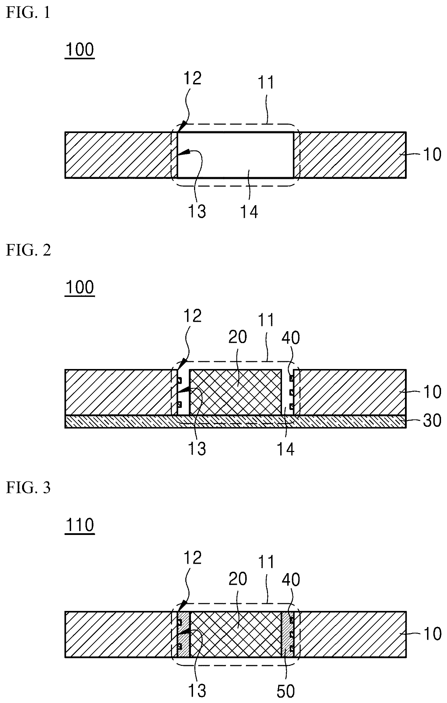

FIG. 1 is a cross-sectional view illustrating a preliminary substrate prepared through a preparation step of the present disclosure. Hereinafter, the present disclosure will be described with reference to FIG. 1.

### Preparation Step

The preliminary substrate (100) may include a core layer (10).

The core layer (10) may function as a support layer in the packaging substrate. The core layer (10) may be applied without limitation as long as it is used as a support layer in the field of packaging substrates. For example, the core layer (10) may be a glass substrate, a ceramic substrate, or an organic substrate.

In particular, the core layer (10) may be a glass substrate. When the glass substrate is applied as the core layer (10), it is advantageous for implementing fine patterns and may stably suppress the generation of parasitic elements.

The glass substrate may be, for example, an alkali borosilicate plate glass, an alkali-free borosilicate plate glass, or an alkali-free alkaline earth borosilicate plate glass, and may be applied as long as it is a plate glass applied to electronic components. The glass substrate may be an electronic device glass substrate, and for example, products manufactured by Schott, AGC, or Corning may be applied, but the present disclosure is not limited thereto.

The core layer (10) may include a through-via (not shown) penetrating the thickness direction of the core layer (10).

The through-via comprises an inner space (not shown) and an inner circumferential surface of the via (not shown) surrounding the inner space. The inner space means an empty space, and the inner circumferential surface of the via means a surface of the core layer (10) formed inside the through-via.

The through-via may have a diameter varying along the thickness direction of the core layer (10). The through-via may have a substantially uniform diameter along the thickness direction of the core layer (10).

A surface of the core layer (10) may include an upper surface and a side surface connected to the upper surface and formed along the thickness direction of the core layer (10). The surface of the core layer (10) may include a lower surface facing the upper surface.

That the side surface is formed along the thickness direction of the core layer (10) is interpreted to mean that at least part of the side surface forms a vertical angle with the upper surface of the core layer (10), and/or that at least a portion of the side surface forms an angle (inclined angle) other than 90 degrees with the upper surface.

The side surface may be a flat surface or a curved surface.

A thickness of the core layer (10) may be 100 $\mu$m or more. The thickness may be 200 $\mu$m or more. The thickness may be 300 $\mu$m or more. The thickness may be 3000 $\mu$m or less. The thickness may be 2000 $\mu$m or less. The thickness may be 1000 $\mu$m or less. In such a case, the core layer (10) may have mechanical properties suitable for application to a packaging substrate.

The core layer (10) may have a cavity portion (11) including a device mounting space (14) and an inner side surface (13) of the cavity surrounding the device mounting space (14).

The cavity portion (11) may be formed by being recessed at the upper surface side of the core layer (10). The cavity portion (11) may be formed by a portion of the upper surface side of the core layer (10) being recessed along the thickness direction of the core layer (10). The cavity portion (11) may be formed by penetrating through the thickness direction of the core layer (10).

The cavity portion (11) may include the device mounting space (14) and the inner side surface (13) of the cavity surrounding the device mounting space (14). The cavity portion (11) includes a cavity opening (12) disposed on the upper surface side of the core layer (10), an inner side surface (13) of the cavity connected to the cavity opening (12) and extending in the thickness direction of the core layer (10), and the device mounting space (14) surrounded by the inner side surface (13) of the cavity.

The cavity opening (12) may be disposed adjacent to the upper surface of the core layer (10). The cavity opening (12) may form an inner edge of the upper surface of the core layer (10).

That the inner side surface (13) of the cavity is formed to extend in the thickness direction of the core layer (10) is interpreted to mean that at least of a portion of the inner side surface (13) forms a vertical angle with the upper surface of the core layer (10), and/or that at least a portion of the inner side surface (13) forms an angle (inclined angle) other than 90 degrees with the upper surface.

The inner side surface (13) of the cavity may be a flat surface or a curved surface.

The preliminary substrate (100) may further include a cavity conductive layer (40) formed on the inner side surface (13) of the cavity. The cavity conductive layer (40) is a conductive layer disposed on the inner side surface (13) of the cavity to transmit an electrical signal in the packaging substrate. The cavity conductive layer (40) may be disposed in contact with the inner side surface (13) of the cavity, or another component may be disposed between the cavity conductive layer (40) and the inner side surface (13) of the cavity.

The inner side surface (13) of the cavity may include an exposed region exposed to the outside. The exposed region is a region of the inner side surface (13) of the cavity that is not covered by the cavity conductive layer (40).

A redistribution layer (not shown) may be formed on the inner side surface (13) of the cavity. The redistribution layer may include the cavity conductive layer (40) and an insulating layer (not shown) surrounding at least a portion of the cavity conductive layer (40).

In the preparation step, a core layer (10) in which the cavity conductive layer (40) has already been formed on the inner side surface (13) of the cavity may be prepared. In the preparation step, the cavity conductive layer (40) may be formed on the inner side surface (13) of the cavity.

A detailed description of the conductive layer, the insulating layer, and the redistribution layer will be given below, and thus omitted here.

The device mounting space (14) is a space in which a device portion is mounted. The device mounting space (14) may be an inner space formed by recessing the upper surface side of the core layer (10).

A description of the device portion will be given below, and thus omitted here.

## Surface Treatment Step

In the present disclosure, in the surface treatment step, surface energy of at least a portion of the inner side surface (13) of the cavity may be increased. In the surface treatment step, surface energy of the cavity conductive layer (40) and the exposed region may be increased. Through this, affinity for the encapsulation layer-forming composition in the region where the encapsulation layer is formed may be effectively increased, and the occurrence of an undulation phenomenon in the insulating layer caused by defects in the encapsulation layer may be effectively suppressed. In particular, even in the cavity portion (11) in which the cavity conductive layer (40) is formed on the inner side surface (13) of the cavity, the surface treatment step of the present disclosure may be effective in forming an encapsulation layer with suppressed voids.

In the surface treatment step, at least a portion of the inner side surface (13) of the cavity may be plasma-treated. In the surface treatment step, the cavity conductive layer (40) and the exposed region of the inner side surface (13) of the cavity may be plasma-treated together. Through plasma treatment, a plurality of functional groups having hydrophilicity may be formed on the surface of the cavity conductive layer (40) and the like. Through this, the hydrophilic encapsulation layer-forming composition may be smoothly filled without voids into a space formed between the device portion mounted in the cavity portion (11) and the inner side surface (13) of the cavity.

In the surface treatment step, an ambient gas may be introduced. In the surface treatment step, the ambient gas may serve as a plasma generating gas.

In the surface treatment step, plasma power may be 50 W or more. The plasma power may be 100 W or more. The plasma power may be 150 W or more. The plasma power may be 200 W or more. The plasma power may be 500 W or more. The plasma power may be 1,000 W or more. The plasma power may be 1,500 W or more. The plasma power may be 2,000 W or more. The plasma power may be 3,000 W or more. The plasma power may be 4,000 W or more. The plasma power may be 5,000 W or more. The plasma power may be 10,000 W or less. In such a case, excessive damage to the cavity conductive layer (40) may be suppressed, and surface properties of the inner side surface (13) of the cavity and the like may be efficiently controlled.

The surface treatment step may be carried out for 15 seconds to 60 seconds. The surface treatment step may be carried out for 17 seconds or more. The surface treatment step may be carried out for 50 seconds or less. The surface treatment step may be carried out for 40 seconds or less. In such a case, the inner side surface (13) of the cavity and the like, having sufficiently improved affinity for the encapsulation layer-forming composition, may be efficiently provided.

The ambient gas may include 50 vol% or more of oxygen gas. The ambient gas may include 60 vol% or more of oxygen gas. The ambient gas may include 70 vol% or more of oxygen gas. The ambient gas may include 100 vol% or less of oxygen gas. In such a case, the surface energy of the inner side surface (13) of the cavity and the like may be controlled to fall within a predetermined range in the present disclosure.

In the surface treatment step, an ambient gas with a controlled flow rate may be introduced. Through this, the inner side surface (13) of the cavity and the like may have surface energy suitable for forming an encapsulation layer. At the same time, it may prevent an adhesive film (30) fixing the device portion (20) from having excessively high affinity for the encapsulation layer, thereby preventing residual adhesive material of the adhesive film (30) from excessively remaining on the surface of the encapsulation layer.

In the surface treatment step, plasma treatment may be performed with 50 sccm to 1000 sccm of ambient gas. In the surface treatment step, plasma treatment may be performed with 100 sccm or more of ambient gas. In the surface treatment step, plasma treatment may be performed with 200 sccm or more of ambient gas. In the surface treatment step, plasma treatment may be performed with 300 sccm or more of ambient gas. In the surface treatment step, plasma treatment may be performed with 800 sccm or less of ambient gas. In the surface treatment step, plasma treatment may be performed with 600 sccm or less of ambient gas. In such a case, while smoothly forming the encapsulation layer, occurrence of defects in the insulating layer caused by adhesive material may be stably suppressed.

In the surface treatment step, a contact angle of water with respect to the inner side surface (13) of the cavity may be adjusted to 60° or less. In the surface treatment step, the contact angle of water with respect to the inner side surface (13) of the cavity may be adjusted to 40° or less. In the surface treatment step, the contact angle of water with respect to the inner side surface (13) of the cavity may be adjusted to 30° or less. In the surface treatment step, the contact angle of water with respect to the inner side surface (13) of the cavity may be adjusted to 25° or less. In the surface treatment step, the contact angle of water with respect to the inner side surface (13) of the cavity may be adjusted to 20° or less. In the surface treatment step, the contact angle of water with respect to the inner side surface (13) of the cavity may be adjusted to 5° or more.

In the surface treatment step, a contact angle of water with respect to the surface of the cavity conductive layer (40) may be adjusted to 60° or less. In the surface treatment step, the contact angle of water with respect to the surface of the cavity conductive layer (40) may be adjusted to 40° or less. In the surface treatment step, the contact angle of water with respect to the surface of the cavity conductive layer (40) may be adjusted to 30° or less. In the surface treatment step, the contact angle of water with respect to the surface of the cavity conductive layer (40) may be adjusted to 25° or less. In the surface treatment step, the contact angle of water with respect to the surface of the cavity conductive layer (40) may be adjusted to 20° or less. In the surface treatment step, the contact angle of water with respect to the surface of the cavity conductive layer (40) may be adjusted to 5° or more.

In such a case, defects caused by differences in surface energy properties between the encapsulation layer-forming composition and other components disposed in the cavity portion may be effectively suppressed.

The contact angle is measured using a surface analyzer. Specifically, water is dropped on the inner side surface of the cavity or the surface of the cavity conductive layer, and the contact angle is measured with the surface analyzer.

**Device Mounting Step**

FIG. 2 is a cross-sectional view illustrating a preliminary substrate prepared through a device mounting step of the present disclosure. Hereinafter, the present disclosure will be described with reference to FIG. 2.

The descriptions of the core layer (10) and the cavity portion (11), etc., in FIG. 1 are equally applicable here. The following will focus on the differences.

The manufacture method for a packaging substrate of the present disclosure may further include a device mounting step of mounting a device portion (20) in the cavity portion (11) after the surface treatment step. The present disclosure may perform fixing of the device portion (20) through an adhesive film (30) after completing the surface treatment step. Through this, it may be effectively suppressed that surface energy of adhesive material included in the adhesive film (30) is excessively increased in the surface treatment step, which would otherwise hinder peeling of the adhesive film (30) or cause the adhesive material to remain on the surface of the encapsulation layer.

The preliminary substrate (100) may further include the device portion (20) disposed in the cavity portion (11). The device portion (20) may be disposed in the device mounting space (14).

The device portion (20) may be fixed within the cavity portion (11) by the adhesive film (30).

The adhesive film (30) may be applied without limitation as long as it is a film used for device fixing in the packaging field. For example, the adhesive film (30) may be a polyimide tape.

The device portion (20) may be a device itself, or may be a device package. The device package is one or more devices packaged by a device insulating material. The device insulating material may surround at least a portion of the surface of the device. The device insulating material may fix one or more devices in the device package and may impart insulation to a desired region in the device package.

The device may include not only semiconductor devices such as a CPU, GPU, and memory chip but also a capacitor device, a transistor device, an impedance device, and other modules. That is, as long as it is a semiconductor device mounted on a semiconductor device, it may be applied without limitation as the device.

The device insulating material may include a material capable of appropriately fixing the device while preventing electrical short circuit. The device insulating material may include, for example, any one selected from the group consisting of epoxy-based resin, polyimide-based resin, polyurethane-based resin, polyester-based resin, acrylate-based resin, polyamide-based resin, and a combination thereof.

The device portion (20) may include a side surface. The side surface of the device portion (20) may be disposed to face apart from a portion of the inner side surface of the cavity.

In the device mounting step, a preliminary substrate (100) in which the gap aspect ratio Arg of Equation 1 below is 30 or less may be prepared.

[Equation 1]

$$Arg = \frac{eh}{g}$$

In Equation 1, eh is the height of the device portion (20), and g is the minimum distance between a first point located on the side surface of the device portion (20) and a second point located on the cavity opening (12).

The present disclosure may control the Arg value of the preliminary substrate (100) to adjust the shape of a space formed between the device portion (20) and the inner side surface (13) of the cavity. Through this, an encapsulation layer-forming composition having a viscosity of a certain level or more may be easily dispensed into the space, thereby efficiently suppressing the formation of voids in the encapsulation layer.

The Arg value of the preliminary substrate (100) may be 30 or less. The Arg value may be 25 or less. The Arg value may be 20 or less. The Arg value may be 15 or less. The Arg value may be 10 or less. The Arg value may be 7 or less. The Arg value may be 0.1 or more. The Arg value may be 0.5 or more. The Arg value may be 1 or more. In such a case, an encapsulation layer-forming composition including filler may sufficiently fill the space formed in the cavity portion (11).

The g value may be 20 $\mu$m to 500 $\mu$m. The g value may be 50 $\mu$m or more. The g value may be 100 $\mu$m or more. The g value may be 400 $\mu$m or less. The g value may be 300 $\mu$m or less.

The eh value may be 300 $\mu$m to 600 $\mu$m. The eh value may be 350 $\mu$m or more. The eh value may be 400 $\mu$m or more. The eh value may be 550 $\mu$m or less.

In such a case, the encapsulation layer-forming composition may be easily filled into the space formed between the inner side surface (13) of the cavity and the device portion (20). In addition, the shape and volume of the formed encapsulation layer may be controlled to contribute to suppressing defects such as wrinkling in the insulating layer formed on the encapsulation layer.

## Encapsulation Layer Forming Step

In the encapsulation layer forming step, an encapsulation layer surrounding at least a portion of the device portion (20) is formed with an encapsulation layer-forming composition. In the encapsulation layer forming step, the encapsulation layer-forming composition may be cured to form the encapsulation layer.

The encapsulation layer forming step may include a placement process of placing the encapsulation layer-forming composition between the inner side surface (13) of the cavity and one side surface of the device portion (20), and a curing process of curing the encapsulation layer-forming composition to form the encapsulation layer.

### Placement Process

The encapsulation layer-forming composition may include an epoxy-based resin and a curing agent.

In the present disclosure, by applying an epoxy-based resin to the encapsulation layer-forming composition, controlled elasticity may be imparted to the encapsulation layer. Through this, while the encapsulation layer sufficiently protects the device portion (20), the encapsulation layer may stably support an insulating layer formed on the encapsulation layer.

The epoxy-based resin may include two or more epoxy groups. The epoxy-based resin may be any one selected from the group consisting of bisphenol A type epoxy resin, brominated bisphenol A type epoxy resin, bisphenol F type epoxy resin, biphenyl type epoxy resin, novolac type epoxy resin, alicyclic epoxy resin, naphthalene type epoxy resin, silicone epoxy copolymer resin, or a combination thereof.

The weight average molecular weight of the epoxy-based resin may be 1,000 g/mol or less. The weight average molecular weight may be 800 g/mol or less. The weight average molecular weight may be 600 g/mol or less. The weight average molecular weight may be 100 g/mol or more.

The curing agent of the present disclosure is not limited as long as it is a compound that may function as a curing agent of the epoxy-based resin. For example, the curing agent may be an acid anhydride-based curing agent, an aromatic amine, a phenol resin, or an imidazole-based compound.

The present disclosure may apply 0.3 equivalent or more of a curing agent per 1 equivalent of an epoxy group in the epoxy-based resin. The present disclosure may apply 0.5 equivalent or more of a curing agent per 1 equivalent of an epoxy group in the epoxy-based resin. The present disclosure may apply 0.7 equivalent or more of a curing agent per 1 equivalent of an epoxy group in the epoxy-based resin. The present disclosure may apply 2 equivalents or less of a curing agent per 1 equivalent of an epoxy group in the epoxy-based resin. The present disclosure may apply 1.5 equivalents or less of a curing agent per 1 equivalent of an epoxy group in the epoxy-based resin.

The encapsulation layer-forming composition may further include a filler. The filler may contribute to the encapsulation layer-forming composition having viscosity within a predetermined range in the present disclosure, and may help the encapsulation layer have physical properties suitable for the packaging substrate.

The filler may include inorganic particles. The filler may be inorganic particles. For example, the filler may include silica, titania, or alumina.

An average particle diameter of the filler may be 150 nm or less. The average particle diameter may be 120 nm or less. The average particle diameter may be 100 nm or less. The average particle diameter may be 80 nm or less. The average particle diameter may be 10 nm or more. The average particle diameter may be 30 nm or more. In such a case, the encapsulation layer-forming composition may have viscosity characteristics suitable for cavity filling, and may help the encapsulation layer have desired mechanical properties. In addition, it may be easy to implement a conductive layer having fine pitch on the encapsulation layer.

The encapsulation layer-forming composition may include 45 wt% or more and 80 wt% or less of filler.

The present disclosure may adjust the filler content in the encapsulation layer-forming composition to fall within a predetermined range in the present disclosure. Through this, the encapsulation layer-forming composition may have flow characteristics suitable for smoothly filling the space formed between the device portion (20) and the inner side surface (13) of the cavity, and the formed encapsulation layer may stably protect the device from external impact and thermal shock.

The encapsulation layer-forming composition may include 45 wt% or more of filler. The encapsulation layer-forming composition may include 50 wt% or more of filler. The encapsulation layer-forming composition may include 80 wt% or less of filler. The encapsulation layer-forming composition may include 75 wt% or less of filler. The encapsulation layer-forming composition may include 70 wt% or less of filler. In such a case, the composition may have flow characteristics suitable for filling the cavity portion (11) in which the device portion (20) is mounted. In addition, the composition may stably fix the device portion (20) and the insulating layer formed on the encapsulation layer within the cavity portion (11), and may form an encapsulation layer that does not apply excessive stress to the core layer (10) during a high-temperature manufacturing process.

The encapsulation layer-forming composition may include a solvent. The solvent is not limited as long as it may be typically applied in the technical field. For example, the solvent may include aliphatic hydrocarbon solvents, aromatic hydrocarbon solvents, ethers, or esters.

The encapsulation layer-forming composition may further include an additive. The additive is not limited as long as it may be typically applied in the technical field. For example, the additive may include a defoamer, a coupling agent, a flame retardant, or a surfactant.

In the placement process, the encapsulation layer-forming composition may be melt-mixed and charged into a region where the encapsulation layer is to be formed. The melt-mixed encapsulation layer-forming composition may be placed through an injection device. The melt-mixed encapsulation layer-forming composition may be placed through a heating cylinder.

The present disclosure may control the temperature of the heating cylinder within a predetermined range in the placement process. Through this, the encapsulation layer-forming composition may have melt viscosity suitable for filling narrow gaps, thereby suppressing the formation of voids in the encapsulation layer.

The temperature of the heating cylinder refers to the temperature measured at the tip of the heating cylinder.

In the placement process, the temperature of the heating cylinder may be 40°C to 70°C. The temperature may be 45°C or more. The temperature may be 50°C or more. The temperature may be 65°C or less. The temperature may be 60°C or less. In such a case, the encapsulation layer-forming composition may sufficiently fill the empty space in the cavity portion (11).

The present disclosure may apply an encapsulation layer-forming composition having controlled viscosity at 25°C. The encapsulation layer-forming composition having viscosity controlled within a predetermined range in the present disclosure may have flow characteristics suitable for filling a space having a complex shape in the cavity portion (11) in the placement process. In addition, the encapsulation layer formed through curing of the composition may have thermal expansion properties suitable for application to a substrate having high hardness.

A viscosity of the encapsulation layer-forming composition at 25°C may be 12,000 cps to 38,000 cps. The viscosity may be 15,000 cps or more. The viscosity may be 18,000 cps or more. The viscosity may be 20,000 cps or more. The viscosity may be 35,000 cps or less. The viscosity may be 32,000 cps or less. The viscosity may be 30,000 cps or less. The viscosity may be 28,000 cps or less. In such a case, the encapsulation layer-forming composition may be smoothly charged into the empty space in the cavity portion, thereby helping suppress the occurrence of defects in the encapsulation layer.

The viscosity of the encapsulation layer-forming composition at 25°C is measured with a viscometer after adjusting the temperature of the composition to 25°C.

Curing Process

FIG. 3 is a cross-sectional view illustrating a packaging substrate manufactured through the manufacture method for a packaging substrate of the present disclosure. Hereinafter, the present disclosure will be described with reference to FIG. 3.

The descriptions of the core layer (10), the device portion (20), and the cavity portion (11), etc., in FIGS. 1 and 2 are equally applicable here. The following will focus on the differences.

In the curing process, the encapsulation layer-forming composition placed in a region for forming the encapsulation layer may be cured to form an encapsulation layer (50). The encapsulation layer-forming composition may be cured by heating to form the encapsulation layer (50).

In the curing process, the heat treatment temperature may be 120°C or more. The heat treatment temperature may be 130°C or more. The heat treatment temperature may be 140°C or more. The heat treatment temperature may be 250°C or less. The heat treatment temperature may be 230°C or less. The heat treatment temperature may be 200°C or less.

In the curing process, the heat treatment time may be 30 minutes or more. The heat treatment time may be 40 minutes or more. The heat treatment time may be 50 minutes or more. The heat treatment time may be 200 minutes or less. The heat treatment time may be 180 minutes or less. The heat treatment time may be 150 minutes or less.

In such a case, the curing reaction may stably proceed within the encapsulation layer-forming composition, thereby helping form the encapsulation layer (50) having excellent physical properties.

In the packaging substrate (110) manufactured through the encapsulation layer forming step, the encapsulation layer (50) may be formed to surround at least a portion of the device portion (20). The encapsulation layer (50) may surround at least a portion of one side surface of the device portion (20). The encapsulation layer (50) may surround all side surfaces of the device portion (20). The encapsulation layer (50) may surround at least a portion of an upper surface of the device portion (20). The encapsulation layer (50) may surround the upper surface of the device portion (20). The encapsulation layer (50) may surround at least a portion of the upper surface and the side surface of the device portion (20). The encapsulation layer (50) may surround at least a portion of the overall surface of the device portion (20).

At least a portion of the encapsulation layer (50) may be disposed in contact with the surface of the device portion (20). The encapsulation layer (50) may be disposed in contact with the surface of the device portion (20). The encapsulation layer (50) may be disposed apart from the surface of the device portion (20).

In the packaging substrate (110) of the present disclosure, an encapsulation layer (50) in which an excessive empty space is not formed may be formed. Through this, the encapsulation layer (50) may stably support and fix the device portion (20), and in implementing a redistribution layer on and/or under the encapsulation layer (50), defects such as undulation in the redistribution layer may be stably suppressed.

The manufactured packaging substrate (110) of the present disclosure may control a difference between thermal expansion characteristics of the encapsulation layer (30) and thermal expansion characteristics of the glass core (10). Through this, even when the substrate is repeatedly exposed to a high-temperature environment during the manufacturing process, such as in an insulating layer forming process, occurrence of defects such as cracks in the glass core (10) may be effectively suppressed.

A difference value between a coefficient of thermal expansion $\alpha1$ of the encapsulation layer (30) and a coefficient of thermal expansion of the glass core (10) may be 40 ppm/°C or less. The difference value may be 35 ppm/°C or less. The difference value may be 30 ppm/°C or less. The difference value may be 5 ppm/°C or more. In this case, an intensity of thermal stress occurring in the glass core (10) in a process of forming an insulating layer on the glass core (10) may be reduced to a level below a certain threshold.

The difference value between the coefficient of thermal expansion $\alpha1$ of the encapsulation layer (30) and the coefficient of thermal expansion of the glass core (10) is an absolute value of a value obtained by subtracting the coefficient of thermal expansion of the glass core (10) from the coefficient of thermal expansion $\alpha1$ of the encapsulation layer (30).

A coefficient of thermal expansion $\alpha2$ of the encapsulation layer (30) may be 140 ppm/°C or less. The $\alpha2$ value may be 135 ppm/°C or less. The $\alpha2$ value may be 130 ppm/°C or less. The $\alpha2$ value may be 125 ppm/°C or less. The $\alpha2$ value may be 120 ppm/°C or less. The $\alpha2$ value may be 115 ppm/°C or less. The $\alpha2$ value may be 110 ppm/°C or less. The $\alpha2$ value may be 100 ppm/°C or more.

In this case, when the packaging substrate (110) is exposed to a high-temperature environment during the manufacturing process, damage to the glass core (10) caused by the encapsulation layer (30) may be stably suppressed.

The coefficient of thermal expansion $\alpha1$ is a coefficient of thermal expansion of a measurement target measured in a temperature range from room temperature to a glass transition temperature of the measurement target. The coefficient of thermal expansion $\alpha2$ is a coefficient of thermal expansion of a measurement target measured in a temperature range higher than the glass transition temperature of the measurement target.

The coefficient of thermal expansion may be measured using a Thermal Mechanical Analyzer (TMA) through a thermomechanical analysis method. For example, the coefficient of thermal expansion may be measured through a Q400 model TMA of TA INSTRUMENTS.

In the present disclosure, elasticity of the encapsulation layer (30) may be controlled within a predetermined range of the present disclosure. In this case, a force applied to the cavity inner side surface (13) by the encapsulation layer (30) thermally expanding in a high-temperature manufacturing environment may be reduced.

A modulus of elasticity of the encapsulation layer (30) may be 10 GPa to 30 GPa. The modulus of elasticity may be 11 GPa or more. The modulus of elasticity may be 12 GPa or more. The modulus of elasticity may be 25 GPa or less. The modulus of elasticity may be 20 GPa or less. The modulus of elasticity may be 15 GPa or less. In this case, stress applied to the cavity inner side surface (13) at high temperature may be reduced.

A modulus of elasticity value of the encapsulation layer (30) may be measured through Dynamic Mechanical Analysis (DMA).

A glass transition temperature of the encapsulation layer (30) may be 70°C to 130°C. The glass transition temperature may be 80°C or more. The glass transition temperature may be 90°C or more. The glass transition temperature may be 100°C or more. The glass transition temperature may be 125°C or less. The glass transition temperature may be 120°C or less. The glass transition temperature may be 115°C or less. Through this, the encapsulation layer (30) may have flexibility suitable for application to the glass core (10) while stably fixing the device portion (20).

The glass transition temperature is measured using a Differential Scanning Calorimeter (DSC). Specifically, after placing a specimen in the DSC, a first scan is carried out by applying a heating rate of 10°C/min for the first scan. After quenching the specimen, a second scan is carried out under the same conditions as the first scan to measure the glass transition temperature and the like.

For example, a Q2000 model of TA Instruments may be applied to measure the glass transition temperature of a first polyester resin.

After forming the encapsulation layer (50), the adhesive film (30) may be peeled and removed.

**Step After Encapsulation Layer Forming Step**

The manufacture method for a packaging substrate of the present disclosure may further include a redistribution layer forming step after the encapsulation layer forming step.

In the redistribution layer forming step, a redistribution layer may be formed on the core layer (10) and the encapsulation layer (50). In the redistribution layer forming step, a redistribution layer may be formed under the core layer (10) and the encapsulation layer (50).

The redistribution layer forming step may include a process of forming a conductive layer and a process of forming an insulating layer.

In the process of forming a conductive layer, the conductive layer may be formed on the surface of the core layer (10) and/or on the insulating layer. In the case of forming a conductive layer on the mounted device, an insulating layer may first be formed on the upper surface of the device, and then the conductive layer may be formed on the insulating layer.

The conductive layer may be formed by a dry method or a wet method.

The dry method is a method of forming a seed layer by sputtering on a region where the conductive layer is to be disposed, and forming the conductive layer by plating on the region in which the seed layer is formed. When forming the seed layer, metals such as titanium, chromium, or nickel may be sputtered, and these metals and copper may be sputtered together. Through sputtering, an anchor effect in which the surface on which the conductive layer is disposed and the deposited metal particles interact may appear, thereby improving adhesion of the conductive layer.

The wet method is a method of performing metal plating after treating a primer on a portion where a conductive layer needs to be formed. The primer may include a compound having a functional group such as an amine. Depending on the degree of adhesion intended, the primer may include both a compound having a functional group such as an amine and a silane coupling agent. When a silane coupling agent is applied, a primer layer may be formed by pretreating a surface to be treated with the silane coupling agent and then coating the pretreated region with a compound having an amine group.

After forming a seed layer or a primer layer, a conductive layer may be formed by plating metal. Copper plating may be applied in forming the conductive layer, but the present disclosure is not limited thereto. Before plating metal, a portion in the seed layer or the primer layer where the conductive layer does not need to be formed may be inactivated, or a portion where the conductive layer needs to be formed may be activated, and then plating may be performed. As methods of activation or inactivation treatment, light irradiation treatment such as irradiating with a laser of a specific wavelength, or chemical treatment may be applied. However, even without applying activation or inactivation treatment, the conductive layer may be patterned by etching after performing metal plating according to a predesigned shape.

In the redistribution layer forming step, an insulating layer may be formed to surround at least a portion of the conductive layer. The insulating layer may be formed to surround at least a portion of the upper surface of the conductive layer. The insulating layer may be formed to surround at least a portion of the side surface of the conductive layer.

The insulating layer and the conductive layer may be disposed in a mixed state on the core layer (10). The conductive layer having a pattern shape may be formed in a form embedded in the insulating layer.

The insulating layer may be applied as long as it may be used as an insulating layer for a semiconductor device or a packaging substrate. For example, the insulating layer may be an epoxy-based resin including a filler. The insulating layer may, for example, be formed by a build-up layer material such as ABF (Ajinomoto Build-up Film) of Ajinomoto Co., or an undercoat material, but the present disclosure is not limited thereto.

The insulating layer may be formed by laminating an uncured or semi-cured insulating film and then curing it.

In the redistribution layer forming step, by completing the formation of a redistribution layer having a predesigned structure on and/or under the core layer (10), a packaging substrate (110) may be prepared.

**Other Step**

If necessary, an upper terminal and the like may be further formed on the upper part and/or side of the packaging substrate (110), and bumps may be further formed on the lower part of the packaging substrate (110). The bumps may be disposed in a predetermined shape under a redistribution layer disposed below the core layer (10). For example, the bumps may be disposed on a portion of the lower surface of the packaging substrate (110) so as to contact a main board or the like.

**The manufacture method for a packaging substrate according to another embodiment**

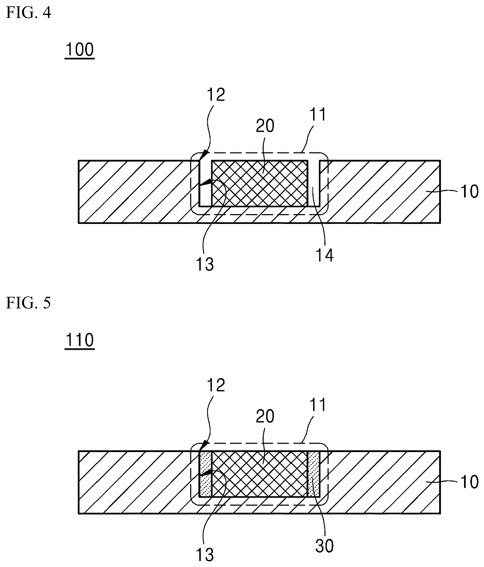

FIG. 4 is a cross-sectional view illustrating a preliminary substrate prepared through a preparation step according to another embodiment of the present disclosure, and FIG. 5 is a cross-sectional view illustrating the packaging substrate manufactured through an encapsulation layer forming step according to another embodiment of the present disclosure. Hereinafter, the embodiment will be described with reference to FIGs. 4 and 5.

A method of manufacturing a packaging substrate according to another embodiment of the present specification comprises a preparation step of preparing a preliminary substrate (100) including a device portion (20) including a device and a core layer (10), which is a glass substrate, on which the device portion (20) is mounted; and an encapsulation layer forming step of manufacturing the packaging substrate (110) by forming an encapsulation layer (50) surrounding at least a portion of the device portion (20) with an encapsulation layer-forming composition.

The core layer (10) comprises a cavity portion (11) that is a space formed by being recessed on an upper surface side of the glass core.

The device portion (20) is disposed in the cavity portion (11).

The glass substrate described above may be applied to the core layer (10). The device portion, preliminary substrate, encapsulation layer-forming composition, encapsulation layer described above may be applied to the device portion (20), preliminary substrate (100), encapsulation layer-forming composition, and encapsulation layer (50). Description for composition, physical properties, structure, etc. of the device portion (20), preliminary substrate (100), encapsulation layer-forming composition, and encapsulation layer (50) is omitted as it is already described above.

The cavity portion (11) may comprise a cavity opening (12) disposed on an upper surface side of the core layer (10), inner side surface (13) of the cavity connected to the cavity opening (12) and extending in a thickness direction of the core layer (10), and a device mounting space (14) surrounded by the inner side surface (13) of the cavity.

The space formed by depression of the upper surface side of the core layer (10) is interpreted to mean not only that a part of the upper surface side of the core layer (10) is depressed in the thickness direction of the core layer (10) to be formed, but also that the core layer (10) is formed to penetrate in the thickness direction.

The cavity opening (12) may be disposed in contact with the upper surface of the core layer (10). The cavity opening (12) may constitute an inner edge of the upper surface of the core layer (10).

That the inner side surface (13) of the cavity is formed to extend in the thickness direction of the core layer (10) is interpreted to mean not only that the inner side surface (13) of the cavity forms a vertical angle with the upper surface of the core layer (10), but also that at least a part of the inner side surface (13) of the cavity forms an angle (inclination angle) other than 90 degrees with the upper surface.

The inner side surface (13) of the cavity may be a plane or may be a curved surface.

At least one side surface of the device portion (20) may be disposed spaced apart from the inner side surface (13) of the cavity facing the one side surface.

The encapsulation layer forming step may comprise a placement process of placing the encapsulation layer-forming composition between the inner side surface (13) of the cavity and one side surface of the device portion (20), and a curing process of curing the encapsulation layer-forming composition to form an encapsulation layer (50).

The encapsulation layer forming step may apply the encapsulation layer forming step described above. The description of the encapsulation layer forming step is omitted since it is duplicated with the foregoing description.

At least one side surface of the device portion (20) may be disposed spaced apart from the inner side surface (13) of the cavity facing the one side surface.

The preliminary substrate (100) may have the Arg, eh, and g values described in Equation 1 above within the numerical ranges described above. The description of the Arg, eh, and g values of the preliminary substrate (100) is omitted since it is duplicated with the foregoing description.

The encapsulation layer (50) may have the physical properties of the encapsulation layer described above. The description of the physical properties of the encapsulation layer (50) is omitted since it is duplicated with the foregoing description.

The encapsulation layer-forming composition may have the composition of the encapsulation layer-forming composition described above. The description of the composition of the encapsulation layer-forming composition is omitted since it is duplicated with the foregoing description.

Hereinafter, the present disclosure will be described in more detail through specific embodiments. The following embodiments are merely examples for understanding the present disclosure, and the scope of the present disclosure is not limited thereto.

**Manufacturing Example: Formation of Packaging Substrate**

Experimental Example 1: A glass substrate having a thickness of 510 $\mu$m and a full cavity of 40 mm to 60 mm in width and 40 mm to 60 mm in length was prepared. A device having a height of 480 $\mu$m was placed in the cavity to prepare a preliminary substrate. The distance between the inner side surface of the cavity and the device was applied as 150 μm, and a polyimide tape was attached to the lower surface of the glass substrate to fix the device.

An empty space formed between the device and the inner side surface of the cavity was filled with encapsulation layer-forming composition U8410-302SNS8AG of Namics Co. through injection equipment. The viscosity of the encapsulation layer-forming composition at 25°C was 25,000 cps, and the temperature of the cylinder tip during filling was applied as 40°C to 60°C.

After completing the filling, the substrate was heat-treated at 150°C to 160°C for 1 hour to 2 hours to form an encapsulation layer, and the polyimide tape was peeled off to manufacture a packaging substrate.

Experimental Example 2: A preliminary substrate in which the device portion was fixed under the same conditions as in Experimental Example 1 was prepared. The surface of the preliminary substrate was plasma-treated. Plasma power of 6000 W was applied, 500 sccm of oxygen gas was introduced as ambient gas, and plasma treatment was carried out for 20 seconds.

After completing the plasma treatment, an encapsulation layer was formed under the same conditions as in Experimental Example 1 to manufacture a packaging substrate.

Experimental Example 3: A packaging substrate was manufactured under the same conditions as in Experimental Example 2, except that plasma power of 3000 W was applied.

Experimental Example 4: A packaging substrate was manufactured under the same conditions as in Experimental Example 2, except that plasma power of 1000 W was applied.

Experimental Example 5: A packaging substrate was manufactured under the same conditions as in Experimental Example 2, except that plasma power of 300 W was applied.

Experimental Example 6: A packaging substrate was manufactured under the same conditions as in Experimental Example 5, except that the flow rate of the ambient gas was applied as 100 sccm.

Experimental Example 7: The surface of the glass substrate applied in Experimental Example 1 was plasma-treated. Plasma power of 6000 W was applied, 500 sccm of oxygen gas was introduced as ambient gas, and plasma treatment was carried out for 20 seconds.

After plasma treatment, a device having a height of 480 μm was placed in the cavity to prepare a preliminary substrate. The distance between the inner side surface of the cavity and the device was applied as 150 μm, and a polyimide tape was attached to the lower surface of the glass substrate to fix the device.

After fixing the device, an encapsulation layer was formed under the same conditions as in Experimental Example 1 to manufacture a packaging substrate.

Experimental Example 8: A packaging substrate was manufactured under the same conditions as in Experimental Example 7, except that plasma power of 3000 W was applied.

Experimental Example 9: A packaging substrate was manufactured under the same conditions as in Experimental Example 7, except that plasma power of 1000 W was applied.

The process conditions of each Experimental Example are described in Table 1 below.

**Evaluation Example: Evaluation of water contact angle on glass substrate surface**

In the manufacturing process of the packaging substrate for each Experimental Example, immediately before filling the cavity portion with an encapsulation layer-forming composition, the water contact angle on the inner side surface of the cavity was measured using a surface analyzer. Specifically, water was dropped onto the inner side surface of the cavity, and the contact angle was measured using the surface analyzer.

The measured values for each Experimental Example are described in Table 2 below.

**Evaluation Example: Evaluation of void formation in encapsulation layer**

In the packaging substrates of Experimental Examples 2 to 9, whether voids occurred in the encapsulation layer was observed with an optical microscope and TEM (Transmission Electron Microscope).

When voids were not found in the encapsulation layer, it was evaluated as P, and when voids were found, it was evaluated as F.

The evaluation results for each Experimental Example are described in Table 2 below.

**Evaluation Example: Evaluation of ink leakage**

The bottom surface of the packaging substrates of Experimental Examples 2 to 9 was observed with an optical microscope, and the extent to which the encapsulation layer-forming composition leaked beyond the inner side surface of the cavity was measured. Specifically, when observed from the bottom surface of the packaging substrate, a first point located at the edge formed where the inner side surface of the cavity and the bottom surface of the packaging substrate meet was specified. From the first point, a straight line was drawn in the direction perpendicular to the edge, and a second point where the straight line met the edge of the encapsulation layer formed on the bottom surface of the packaging substrate was specified. The distance between the first point and the second point was measured. The maximum value of the distance measurement was calculated and defined as the ink leakage distance of the corresponding Experimental Example.

The measured values for each Experimental Example are described in Table 2 below.

**Evaluation Example: Evaluation of peelability of polyimide tape**

In the manufacturing process of the packaging substrates of Experimental Examples 4 and 6 to 9, after completing the formation of the encapsulation layer, the adhesion force between the encapsulation layer and the polyimide tape was measured using a Condor Sigma bond tester from XYZ TEC according to a 180° peel test. The measurement speed (peel speed) was set to 10 mm/s, and the measurement distance (peel distance) was set to 70 mm.

The measured values for each Experimental Example are described in Table 2 below.

**Evaluation Example: Evaluation of residual adhesive material**

The bottom surface of the packaging substrates of Experimental Examples 4 and 6 to 9 was observed with an optical microscope and TEM (Transmission Electron Microscope) to check whether the adhesive material of the polyimide film remained on the bottom surface of the packaging substrate. When adhesive material did not remain, it was evaluated as P, and when adhesive material remained, it was evaluated as F.

The evaluation results for each Experimental Example are described in Table 2 below.

[Table 1]

| | whether plasma treatment is performed | whether the device is fixed after plasma treatment | Plasma power (W) | Ambient gas flow rate (sccm) | Plasma treatment time (seconds) |
|---|---|---|---|---|---|
| Experimental Example 1 | X | - | - | - | - |
| Experimental Example 2 | O | X | 6000 | 500 | 20 |
| Experimental Example 3 | O | X | 3000 | 500 | 20 |
| Experimental Example 4 | O | X | 1000 | 500 | 20 |
| Experimental Example 5 | O | X | 300 | 500 | 20 |
| Experimental Example 6 | O | X | 300 | 100 | 20 |
| Experimental Example 7 | O | O | 6000 | 500 | 20 |
| Experimental Example 8 | O | O | 3000 | 500 | 20 |
| Experimental Example 9 | O | O | 1000 | 500 | 20 |

[Table 2]

| | Contact angle (°) | Evaluation of void formation | Ink leakage evaluation (mm) | Peel strength of polyimide tape (gf/cm$^2$) | Evaluation of residual adhesive material |
|---|---|---|---|---|---|
| Experimental Example 1 | 110 | - | - | - | - |
| Experimental Example 2 | 15.6 | P | 10 | - | - |
| Experimental Example 3 | 19.7 | P | 6 | - | - |
| Experimental Example 4 | 22.1 | P | 0.5 | 400 | F |
| Experimental Example 5 | 26.6 | P | 6 | - | - |
| Experimental Example 6 | 29.1 | P | 2 | 450 | F |
| Experimental Example 7 | 17.9 | P | < 0.5 | < 150 | P |

(continued)

|  | Contact angle (°) | Evaluation of void formation | Ink leakage evaluation (mm) | Peel strength of polyimide tape (gf/cm$^2$) | Evaluation of residual adhesive material |
|---|---|---|---|---|---|
| Experimental Example 8 | 18.2 | P | < 0.5 | < 150 | P |
| Experimental Example 9 | 23.5 | P | < 0.5 | < 150 | P |

From the results of the contact angle measurement described in Table 2, in the case of Experimental Example 1 without applying plasma treatment, a value of 100° or more was shown, whereas Experimental Examples 2 to 9 with plasma treatment showed values of 30° or less.

In the evaluation of void formation, Experimental Examples 2 to 9 with plasma treatment did not show voids.

In the evaluation of ink leakage, Experimental Examples 7 to 9, in which device fixation was carried out after plasma treatment, were measured to be less than 0.5 mm, whereas among Experimental Examples 2 to 6, in which plasma treatment was carried out after device fixation, Experimental Examples 2, 3, and 5 were measured to be 6 mm or more.

In the evaluation of peel strength of polyimide tape, Experimental Examples 7 to 9, in which device fixation was carried out after plasma treatment, were measured to have peel strength of less than 150 gf/cm$^2$, and no residual adhesive material was found. In contrast, Experimental Examples 4 and 6, in which plasma treatment was carried out after device fixation, showed values of 400 gf/cm$^2$ or more in peel strength, and residual adhesive material was found.

**Preparation Example: Formation of Packaging Substrate**

Example 1: A glass substrate having a thickness of 510 $\mu$m and a full cavity formed with a width of 40 mm to 60 mm and a length of 40 mm to 60 mm was prepared. A device having a height of 480 $\mu$m was disposed in the cavity. A distance between the cavity inner side surface and the device was applied as 150 $\mu$m, and a polyimide tape was attached to a lower surface of the glass substrate to fix the position of the device.

Subsequently, an empty space formed between the device and the cavity inner side surface was filled with U8410-302SNS8AG, an encapsulation layer-forming composition of Namics, through injection equipment. During filling, a temperature of a cylinder tip was applied as 40°C to 60°C.

After completion of filling, the substrate was heat-treated at 150°C to 160°C for 1 hour to 2 hours to form an encapsulation layer.

After formation of the encapsulation layer, an insulating layer was formed by laminating and curing ABF GL103, a build-up film having a thickness of 20 $\mu$m, on the glass substrate to prepare the packaging substrate.

Example 2: A packaging substrate was prepared under the same conditions as in Example 1, except that U8410-207R6 of Namics was applied as the encapsulation layer-forming composition.

Example 3: A packaging substrate was prepared under the same conditions as in Example 1, except that U8410-302 of Namics was applied as the encapsulation layer-forming composition.

Comparative Example 1: A packaging substrate was prepared under the same conditions as in Example 1, except that 8803LF (Rev.3) of Poly Tech was applied as the encapsulation layer-forming composition.

Comparative Example 2: A packaging substrate was prepared under the same conditions as in Example 1, except that U8437-2 of Namics was applied as the encapsulation layer-forming composition.

Comparative Example 3: A packaging substrate was prepared under the same conditions as in Example 1, except that U8410-406 of Namics was applied as the encapsulation layer-forming composition.

Comparative Example 4: A packaging substrate was prepared under the same conditions as in Example 1, except that 8507FS of Poly Tech was applied as the encapsulation layer-forming composition.

Processing conditions for each Example and Comparative Example are described in Table 3 below.

**Evaluation Example: Evaluation of Physical Properties of Encapsulation Layer**

Values of coefficients of thermal expansion of the encapsulation layer and the glass substrate were measured for each Example and Comparative Example. The coefficient of thermal expansion was measured with a TMA (Thermal Mechanical Analyzer) of Q400 model of TA INSTRUMENTS using a thermomechanical analysis method.

Thereafter, after separating a portion of the encapsulation layer from the packaging substrates of each Example and Comparative Example, a modulus of elasticity of the separated encapsulation layer was measured. The modulus of elasticity was measured through Dynamic Mechanical Analysis (DMA).

The glass transition temperature of the separated encapsulation layer was measured using a Differential Scanning Calorimeter (DSC) Q2000 of TA Instruments.

The measurement values for each Example and Comparative Example are described in Table 4 below.

**Evaluation Example: Evaluation of Crack Occurrence in Glass Substrate**

After forming the encapsulation layer by placing and curing the encapsulation layer-forming composition in the glass substrate in the packaging substrate manufacturing process of each Example and Comparative Example, the glass substrate was observed with an optical microscope.

After forming the encapsulation layer, an insulating layer was formed by laminating and curing a build-up film on the glass substrate, and the glass substrate was observed with an optical microscope.

After forming the insulating layer, the packaging substrate was left to complete final curing for 20 minutes at 120°C, and then the glass substrate was observed with an optical microscope.

At this time, when a defect having a length of 100 μm or more was present in the glass substrate, it was determined as a crack. When a crack did not occur, it was judged as P, and when a crack occurred, it was judged as F.

The evaluation results for each Example and Comparative Example are described in Table 5 below.

**Evaluation Example: Moisture Resistance Evaluation**

Each packaging substrate of the Examples and Comparative Examples was left in an atmosphere of 125°C for 24 hours, and then left in an atmosphere of 30°C, 60% RH for 96 hours. Thereafter, whether delamination of the encapsulation layer and the insulating layer occurred was observed with an optical microscope. When delamination of neither the encapsulation layer nor the insulating layer occurred, it was evaluated as P, and when delamination occurred in at least one of the encapsulation layer or the insulating layer, it was evaluated as F.

The evaluation results for each Example and Comparative Example are described in Table 5 below.

**Evaluation Example: Heat Resistance Evaluation**

The temperature of an atmosphere in which each packaging substrate of the Examples and Comparative Examples was placed was lowered to -40°C, and then the atmospheric temperature was raised to 165°C over 1 hour, and the atmospheric temperature was maintained at 165°C for 2 hours. Thereafter, the atmospheric temperature was lowered to -40°C over 1 hour. This process was performed as one thermal cycle, and a total of 100 thermal cycles were performed, and whether cracks occurred in the glass substrate and whether delamination of the encapsulation layer occurred were observed with an optical microscope.

Thereafter, an additional total of 400 thermal cycles were performed, and whether cracks occurred in the glass substrate and whether delamination of the encapsulation layer occurred were observed with an optical microscope.

When it was observed with an optical microscope that cracks did not occur in the glass substrate and delamination of the encapsulation layer and the insulating layer did not occur, it was evaluated as P, and when cracks occurred in the glass substrate or delamination occurred in at least one of the encapsulation layer or the insulating layer, it was evaluated as F.

The evaluation results for each Example and Comparative Example are described in Table 5 below.

**Evaluation Example: HTSL (High Temperature Storage Life) Evaluation**

Each packaging substrate of the Examples and Comparative Examples was heated at 150°C for 500 hours, and then whether cracks occurred in the glass substrate and whether delamination of the encapsulation layer and the insulating layer occurred were evaluated.

When cracks did not occur in the glass substrate and delamination of the encapsulation layer and the insulating layer did not occur, it was evaluated as P, and when cracks occurred in the glass substrate or delamination occurred in at least one of the encapsulation layer or the insulating layer, it was evaluated as F.

The evaluation results for each Example and Comparative Example are described in Table 5 below.

[Table 3]

| | Encapsulation layer-forming composition | Viscosity at 25°C (cps) | Filler content in composition (wt%) |
|---|---|---|---|
| Example 1 | U8410-302SNS8AG | 25,000 | 53 |
| Example 2 | U8410-207R6 | 20,000 | 60 |

(continued)

|  | Encapsulation layer-forming composition | Viscosity at 25°C (cps) | Filler content in composition (wt%) |
|---|---|---|---|
| Example 3 | U8410-302LF1 | 20,000 | 60 |
| Comparative Example 1 | 8803LF(Rev.3) | 6,700 | 40 |
| Comparative Example 2 | U8437-2 | 40,000 | 65 |
| Comparative Example 3 | U8410-406 | 40,000 | 70 |
| Comparative Example 4 | 8507FS | 10,500 | 50 |

[Table 4]

|  | CTE $\alpha1$ (ppm/°C) | CTE $\alpha2$ (ppm/°C) | Glass transition temperature (°C) | Modulus of elasticity (GPa) |
|---|---|---|---|---|
| Example 1 | 29 | 126 | 113 | 12 |
| Example 2 | 29 | 109 | 92 | 13 |
| Example 3 | 29 | 102 | 108 | 12 |
| Comparative Example 1 | 26 | 154 | 164 | 9 |
| Comparative Example 2 | 32 | 100 | 137 | 7 |
| Comparative Example 3 | 19 | 70 | 178 | 6.8 |
| Comparative Example 4 | 40 | 150 | 10 | 3 |

[Table 5]

|  | Crack occurrence evaluation (after encapsulation layer formation) | Crack occurrence evaluation (after insulating layer formation) | Crack occurrence evaluation (after final curing) | Moisture resistance evaluation | Heat resistance evaluation (100 cycles) | Heat resistance evaluation (500 cycles) | HTSL evaluation |
|---|---|---|---|---|---|---|---|
| Example 1 | P | P | P | P | P | P | P |
| Example 2 | P | P | P | P | P | P | P |
| Example 3 | P | P | P | P | P | P | P |
| Comparative Example 1 | P | P | P | F | F | F | F |
| Comparative Example 2 | F | F | F | F | P | P | F |
| Comparative Example 3 | P | P | P | F | F | F | F |
| Comparative Example 4 | P | F | F | F | F | F | F |

In Table 5 above, Examples 1 to 3 were all evaluated as P in the crack occurrence evaluation, the moisture resistance evaluation, the heat resistance evaluation, and the HTSL evaluation, whereas in the case of Comparative Example 1, it was evaluated as F in the moisture resistance evaluation, the heat resistance evaluation, and the HTSL evaluation. These evaluation results support that, when the encapsulation layer-forming composition having controlled viscosity and the like of the present disclosure is applied to the method of manufacturing a packaging substrate, and a position of the device portion in the cavity portion is adjusted as intended in the present disclosure, the moisture resistance, heat resistance, and delamination resistance of the encapsulation layer may be improved, and stress applied to the glass substrate may be reduced.

Although the preferred embodiments of the present invention have been described in detail above, the scope of rights of the present invention is not limited thereto, and various modifications and improved forms using the basic concept of the present invention defined in the following claims by those skilled in the art also belong to the scope of rights of the present invention.

[Explanation of Reference Numerals]

100: Preliminary substrate
110: Packaging substrate
10: Core layer
11: Cavity portion
12: Cavity opening
13: Inner side surface of the cavity
14: Device mounting space
20: Device portion
30: Adhesive film
40: Cavity conductive layer
50: Encapsulation layer

**Claims**

1. A method of manufacturing a packaging substrate, comprising:

    a preparation step of preparing a preliminary substrate which comprises a core layer in which a cavity portion comprises a device mounting space and an inner side surface of the cavity surrounding the device mounting space;
    a surface treatment step of increasing surface energy of at least a portion of the inner side surface of the cavity;
    a device portion mounting step which comprises mounting a device portion on the cavity portion after the surface treatment step is completed; and
    an encapsulation layer forming step of forming an encapsulation layer which comprises surrounding at least a portion of the surface of the device portion with an encapsulation layer-forming composition.

2. The method of manufacturing a packaging substrate of claim 1,

    wherein the preliminary substrate further comprises a cavity conductive layer formed on the inner side surface of the cavity,
    wherein the inner side surface of the cavity comprises an exposed region not covered with the cavity conductive layer, and
    wherein in the surface treatment step, surface energies of the cavity conductive layer and the exposed region are increased.

3. The method of manufacturing a packaging substrate of claim 1,
    wherein in the surface treatment step, at least a portion of the inner side surface of the cavity is plasma treated.

4. The method of manufacturing a packaging substrate of claim 3,
    wherein in the surface treatment step, an ambient gas comprises 50 volume% or more of oxygen gas.

5. The method of manufacturing a packaging substrate of claim 3,
    wherein in the surface treatment step, plasma power is 50W or more.

6. The method of manufacturing a packaging substrate of claim 3,
    wherein the surface treatment step is performed for 15 seconds to 60 seconds.

7. The method of manufacturing a packaging substrate of claim 3,

wherein in the surface treatment step, plasma treatment is performed with an ambient gas of 50 sccm to 1000 sccm.

8. The method of manufacturing a packaging substrate of claim 1,
wherein in the surface treatment step, a contact angle of water with respect to the inner side surface of the cavity is adjusted to 60° or less.

9. The method of manufacturing a packaging substrate of claim 1,

wherein the device portion comprises a side surface disposed spaced apart from the inner side surface of the cavity,
and a gap aspect ratio arg of equation 1 below is 30 or less:

[Equation 1]

$$Arg = \frac{eh}{g}$$

in equation 1, eh is a height of the device portion, and g is a minimum distance between a first point located on a side surface of the device portion and a second point located on the inner side surface of the cavity.

10. The method of manufacturing a packaging substrate of claim 9,
wherein the value of g is 20 $\mu$m to 500 $\mu$m.

11. The method of manufacturing a packaging substrate of claim 1,
wherein viscosity of the encapsulation layer-forming composition at 25°C is 12,000 cps to 38,000 cps.

12. The method of manufacturing a packaging substrate of claim 1,
wherein the encapsulation layer-forming composition comprises 45 wt% or more and 80 wt% or less of filler.

13. The method of manufacturing a packaging substrate of claim 1,
wherein a difference value between a coefficient of thermal expansion $\alpha1$ of the encapsulation layer and a coefficient of thermal expansion of the core layer is 40 ppm/°C or less.

14. The method of manufacturing a packaging substrate of claim 1,
wherein a coefficient of thermal expansion $\alpha2$ of the encapsulation layer is 140 ppm/°C or less.

15. A method of manufacturing a packaging substrate, comprising:

a preparation step of preparing a preliminary substrate including a device portion including a device and a core layer on which a device portion is mounted; and
an encapsulation layer forming step of manufacturing the packaging substrate by forming an encapsulation layer surrounding at least a portion of the device portion with an encapsulation layer-forming composition;
wherein the core layer comprises a cavity portion that is a space formed by being recessed on an upper surface side of the core layer;
wherein the device portion is disposed in the cavity portion; and
wherein a viscosity of the encapsulation layer-forming composition at 25°C is 12,000 cps to 38,000 cps.

FIG. 1

100

FIG. 2

100

FIG. 3

110

FIG. 4

100

FIG. 5

110

| | Europäisches Patentamt<br>European Patent Office<br>Office européen des brevets | **EUROPEAN SEARCH REPORT** | **Application Number**<br><br>EP 25 20 6408 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 2021/159200 A1 (LEE CHIH CHENG [TW])<br>27 May 2021 (2021-05-27)<br>* paragraphs [0027], [0031], [0035], [0037]; figures 5A-5F * | 1,3-15<br><br>2 | INV.<br>H01L23/15<br><br>ADD.<br>H01L21/56 |
| A | DATABASE INSPEC [Online]<br>THE INSTITUTION OF ELECTRICAL ENGINEERS, STEVENAGE, GB;<br>15 March 2015 (2015-03-15),<br>BONOVA L ET AL: "Atmospheric pressure plasma treatment of flat aluminum surface",<br>XP093344148,<br>Database accession no. 14952698<br>* the whole document *<br>& APPLIED SURFACE SCIENCE ELSEVIER B.V. NETHERLANDS,<br>vol. 331, 15 March 2015 (2015-03-15),<br>pages 79-86,<br>ISSN: 0169-4332, DOI:<br>10.1016/J.APSUSC.2015.01.030 | 3-8 | H01L23/28<br>H01L23/538 |
| A | DATABASE MEDLINE [Online]<br>US NATIONAL LIBRARY OF MEDICINE (NLM), BETHESDA, MD, US;<br>23 April 2023 (2023-04-23),<br>TSAI DU-CHENG ET AL: "Influence of Plasma Treatment on Surface Characteristics of Aluminum Alloy Sheets and Bonding Performance of Glass Fiber-Reinforced Thermoplastic/Al Composites.",<br>XP093344150,<br>Database accession no. NLM37176199<br>* the whole document *<br>-/-- | 3-8 | **TECHNICAL FIELDS SEARCHED (IPC)**<br><br>H01L |

The present search report has been drawn up for all claims

| Place of search | Date of completion of the search | Examiner |
|---|---|---|
| The Hague | 5 December 2025 | Bürkle, Marius |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

Europäisches Patentamt

European Patent Office

Office européen des brevets

## EUROPEAN SEARCH REPORT

**Application Number**

EP 25 20 6408

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| | & TSAI DU-CHENG ET AL: "Influence of Plasma Treatment on Surface Characteristics of Aluminum Alloy Sheets and Bonding Performance of Glass Fiber-Reinforced Thermoplastic/Al Composites.", MATERIALS (BASEL, SWITZERLAND) 23 APR 2023, vol. 16, no. 9, 23 April 2023 (2023-04-23) , ISSN: 1996-1944 ----- | | |
| A | WO 2013/008552 A1 (IBIDEN CO LTD [JP]; SHIMIZU KEISUKE [JP] ET AL.) 17 January 2013 (2013-01-17) * figures 3,25 * ----- | 9,10 | |
| | | | **TECHNICAL FIELDS SEARCHED (IPC)** |

The present search report has been drawn up for all claims

| Place of search | Date of completion of the search | Examiner |
|---|---|---|
| The Hague | 5 December 2025 | Bürkle, Marius |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................

& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 25 20 6408

This annex lists the patent family members relating to the patent documents cited in the above-mentioned European search report.
The members are as contained in the European Patent Office EDP file on
The European Patent Office is in no way liable for these particulars which are merely given for the purpose of information.

05-12-2025

| Patent document cited in search report | Publication date | Patent family member(s) | | Publication date |
|---|---|---|---|---|
| US 2021159200 A1 | 27-05-2021 | CN | 112864104 A | 28-05-2021 |
| | | US | 2021159200 A1 | 27-05-2021 |
| WO 2013008552 A1 | 17-01-2013 | NONE | | |

EPO FORM P0459

For more details about this annex : see Official Journal of the European Patent Office, No. 12/82

**REFERENCES CITED IN THE DESCRIPTION**

**Patent documents cited in the description**

- US 63739108

- US 63707741